(19) Europäisches Patentamt
European Patent Office
Office européen des brevets

(11) **EP 2 510 373 B1**

(12) **EUROPÄISCHE PATENTSCHRIFT**

(45) Veröffentlichungstag und Bekanntmachung des Hinweises auf die Patenterteilung:
**26.02.2014 Patentblatt 2014/09**

(51) Int Cl.:
***G01R 19/00*** *(2006.01)*     ***G01R 35/00*** *(2006.01)*
***G01R 15/04*** *(2006.01)*     ***G01R 31/40*** *(2014.01)*

(21) Anmeldenummer: **10787720.1**

(22) Anmeldetag: **24.11.2010**

(86) Internationale Anmeldenummer:
**PCT/EP2010/068104**

(87) Internationale Veröffentlichungsnummer:
**WO 2011/069825 (16.06.2011 Gazette 2011/24)**

(54) **Verfahren und Vorrichtung zum Kalibrieren einer Spannungsmessung an einer Treiberschaltung für eine elektrische Maschine**

Method and device for calibrating a voltage measurement on a driver circuit for an electrical machine

Procédé et dispositif d'étalonnage de la mesure d'une tension sur un circuit de commande pour une machine électrique

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.12.2009 DE 102009047608**

(43) Veröffentlichungstag der Anmeldung:
**17.10.2012 Patentblatt 2012/42**

(73) Patentinhaber: **Robert Bosch GmbH**
**70442 Stuttgart (DE)**

(72) Erfinder: **FRICKER, David**
**F-67240 Oberhoffen sur Moder (FR)**

(56) Entgegenhaltungen:
**DE-A1- 19 644 765**     **DE-B3- 10 359 236**
**DE-C1- 19 947 301**     **JP-A- 10 234 198**

**Beschreibung**

Technisches Gebiet

Die Erfindung betrifft Verfahren und Vorrichtungen zum Messen von Klemmenspannungen in einer Treiberschaltung, insbesondere bei Treiberschaltung zum Betreiben eines Elektromotors. Insbesondere betrifft die vorliegende Erfindung das Kalibrieren der Spannungsmessung zum Messen der Klemmenspannung in der Treiberschaltung.

Stand der Technik

Motorsysteme weisen oftmals neben einer elektrischen Maschine auch eine entsprechende Treiberschaltung auf, um die elektrische Maschine insbesondere mit mehreren Leistungsstufen, anzusteuern. Die Treiberschaltung umfasst in der Regel zwei oder mehr als zwei Halbbrückenschaltungen, so genannte Inverterschaltungen, die im Wesentlichen eine Serienschaltung von zwei Leistungshalbleiterschaltern aufweisen. Zwischen den Leistungshalbleiterschaltern befindet sich ein Mittenanschluss, der mit einem zugeordneten Motoranschluss verbunden ist. Je nach Schaltzustand der Leistungshalbleiterschalter wird der Mittenanschluss entweder mit einem hohem oder mit einem niedrigen Versorgungspotenzial verbunden.

Je nach anzusteuerndem Elektromotor ist es für den Betrieb des Elektromotors notwendig, Klemmenspannungen an den Motoranschlüssen zu erfassen. Diese werden in der Regel mit Hilfe einer geeigneten Aufbereitungsschaltung (zum Beispiel einem Spannungsteiler oder dergleichen) und einem Spannungsmesser, z.B. einem Analog-Digital-Wandler, erfasst und eine entsprechende Spannungsangabe einer die Treiberschaltung ansteuernden Steuereinheit zugeführt. Für die Erfassung der Klemmenspannung gelten bestimmte Genauigkeitsanforderungen, die bislang dadurch erfüllt werden, dass für den Aufbau der Aufbereitungsschaltung Bauteile mit engen Toleranzen, z.B. Präzisionswiderstände, eingesetzt werden. Die Verwendung derartiger Präzisionsbauteile ist jedoch aufwendig, da diese in einem Auswahlprozess entsprechend selektiert werden müssen.

Dokument DE 103 59 236 B3 offenbart ein Motorsystem mit einer dreiphasigen elektrischen Maschine und einer Treiberschaltung. Die Motoranschlüsse sind dabei über Spannungsteiler mit der Steuereinheit zum Messern der jeweiligen Klemmenspannung verbunden. Weiterhin offenbart Dokument DE 199 47 301 C1 in allgemeiner Form zur Stromsensorkalibrierung die Ausgestaltung eines Steuergeräts zur Durchführung einer linearen Interpolation von zwei bei unterschiedlichen und bekannten Bedingungen gemessenen Sensorspannungswertepaaren wobei die lineare Interpolation dabei einen Korrekturfaktor beschreibt. Schließlich offenbart Dokument DE 196 44 765 A1 in einem Verfahren zum Abgleich von Messschaltanordnungen die Ermittlung eines Korrekturfaktors durch einen hinzugefügten bekannten Messwiderstand und den bekannten Sollwert eines Referenzwiderstands mittels einer Spannungsmessung.

Es ist daher Aufgabe der vorliegenden Erfindung ein Verfahren und eine Vorrichtung zur Messung der Klemmenspannung in einem Motorsystem zur Verfügung zu stellen, um mit den Klemmenspannungen an einem Elektromotor präzise erfasst werden können, ohne dafür Präzisionsbauteile bzw. Bauteile mit engen Toleranzen für die Aufbereitungsschaltung vorzusehen.

Offenbarung der Erfindung

Diese Aufgabe wird durch das Verfahren zum Kalibrieren einer Spannungsmessung einer Klemmenspannung für eine elektrische Maschine gemäß Anspruch 1 sowie durch die Vorrichtung gemäß Anspruch 5 und das Motorsystem gemäß den nebengeordneten Ansprüchen gelöst.

Weitere vorteilhafte Ausgestaltungen sind in den abhängigen Ansprüchen angegeben.

Gemäß einem ersten Aspekt ist ein Verfahren zur Kalibrierung einer Spannungsmessung, insbesondere zur Messung einer Klemmenspannung einer Treiberschaltung für eine elektrische Maschine, vorgesehen. Das Verfahren umfasst die folgenden Schritte:

- Schalten der Treiberschaltung, so dass ein erstes definiertes Potenzial, insbesondere ein erstes Versorgungspotenzial, an einen Klemmenanschluss angelegt wird;
- Messen einer Spannung an einem Motoranschluss bei angelegtem ersten definierten Potenzial, um eine erste Spannungsangabe zu erhalten, wobei die erste Spannungsangabe bei dem angelegten ersten definierten Potential durch Messen einer durch die Aufbereitungsschaltung aufbereiteten Spannung erhalten wird, die sich durch eine, insbesondere lineare Abbildung der an dem Motoranschluss anliegenden Spannung ergibt;
- Schalten der Treiberschaltung, so dass ein zweites definiertes Potenzial, insbesondere ein zweites Versorgungspotenzial, an einen Klemmenanschluss angelegt wird;
- Messen der Spannung an dem Motoranschluss bei angelegtem zweiten Potential, um eine zweite Spannungsangabe zu erhalten, wobei die zweite Spannungsangabe bei dem angelegten zweiten definierten Potential durch Messen einer durch die Aufbereitungsschaltung aufbereiteten Spannung erhalten wird, die sich durch eine, insbesondere lineare Abbildung der an dem Motoranschluss anliegenden Spannung ergibt;

- Ermitteln eines Korrekturfaktors als Steigung einer von der ersten und der zweiten Spannungsangabe definierten Gerade, wobei mit dem Korrekturfaktor eine an dem Motoranschluss gemessene Spannung beaufschlagbar ist, um die reale Klemmenspannung zu erhalten.

Eine Idee des obigen Verfahrens besteht darin, die aufbereitete Spannung, die zum Beispiel durch einen Spannungsteiler erzeugt wird, zu kalibrieren. Dazu wird zunächst eine Inverterschaltung, die dem Motoranschluss, an dem die Klemmenspannung gemessen werden soll, zugeordnet ist, so angesteuert, dass der Motoranschluss mit dem ersten definierten Potenzial verbunden wird. Die resultierende Klemmenspannung wird dann über die Aufbereitungsschaltung abgegriffen und eine erste Spannungsangabe ermittelt, die die aufbereitete Klemmenspannung angibt. Die Klemmenspannung ist dann zum Beispiel entsprechend der Abbildung der Aufbereitungsschaltung, z.B. des Widerstandsverhältnisses des Spannungsteilers, heruntergeteilt. Anschließend wird die Inverterschaltung so angesteuert, dass der Motoranschluss mit dem zweiten definierten Potenzial verbunden wird und eine entsprechende aufbereitete Klemmenspannung wird durch die Spannungsmessung erfasst. Abhängig von der ersten Spannungsangabe und der zweiten Spannungsangabe und insbesondere abhängig von der Differenz zwischen dem ersten definierten Potenzial und dem zweiten definierten Potenzial kann jede gemessene Klemmenspannung in die tatsächliche Klemmenspannung umgerechnet werden. Dies kann durchgeführt werden, indem die gemessene Klemmenspannung auf die tatsächliche Klemmenspannung linear abgebildet wird. Dazu wird als einer der Koeffizienten des linearen Zusammenhangs die Steigung der Übertragungsfunktion ermittelt, mit der die gemessene Spannung korrigiert werden muss, um die tatsächliche Klemmenspannung zu erhalten.

Weiterhin kann das erste definierte Potenzial einem ersten Versorgungspotenzial und das zweite definierte Potenzial einem zweiten Versorgungspotenzial entsprechen, wobei die Versorgungsspannung der Spannungsdifferenz zwischen dem ersten und dem zweiten Versorgungspotenzial entspricht, wobei zur Ermittlung des Korrekturfaktors die Versorgungsspannung gemessen wird, wobei der Korrekturfaktor als das Verhältnis zwischen der Versorgungsspannung und der Differenz zwischen dem ersten Versorgungspotenzial und dem zweiten Versorgungspotenzial ermittelt wird.

Gemäß einer weiteren Ausführungsform kann aus der ersten und der zweiten Spannungsangabe ein Offset ermittelt werden, wobei mit dem Offset eine an dem Motoranschluss gemessene Spannung beaufschlagbar ist, um die reale Klemmenspannung zu erhalten.

Gemäß einem weiteren Aspekt ist ein Verfahren zum Bestimmen einer aktuellen Klemmenspannung vorgesehen. Das Verfahren umfast die folgenden Schritte:

- Messen der Spannung an dem Motoranschluss, um eine Spannungsangabe zu erhalten; und
- Ermitteln der aktuellen Klemmenspannung aus der Spannungsangabe und aus dem gemäß dem obigen Verfahren zum Kalibrieren ermittelten Korrekturfaktor.

Gemäß einem weiteren Aspekt ist eine Vorrichtung zum Kalibrieren einer Spannungsmessung, insbesondere für die Messung einer Klemmenspannung einer Treiberschaltung für eine elektrische Maschine, vorgesehen. Die Vorrichtung umfasst:

- ein Steuergerät das ausgebildet ist,
- um für eine erste Messung die Treiberschaltung anzusteuern, so dass ein erstes definiertes Potenzial, insbesondere ein ersten Versorgungspotenzial, an einen Klemmenanschluss angelegt wird;
- um für eine zweite Messung die Treiberschaltung anzusteuern, so dass ein zweites definiertes Potenzial, insbesondere ein zweites Versorgungspotenzial, an einen Klemmenanschluss angelegt wird;
- eine Aufbereitungsschaltung, insbesondere einen Spannungsteiler, um eine durch das Potenzial an dem Klemmenanschluss bestimmte Spannung zu modifizieren, so dass eine aufbereitete Klemmenspannung erhalten wird;
- eine Messeinheit,
- um bei der ersten Messung die aufbereitete Klemmenspannung an einem Motoranschluss bei angelegtem ersten definierten Potenzial zu messen, um eine erste Spannungsangabe zu erhalten;
- um bei der zweiten Messung die aufbereitete Klemmenspannung an dem Motoranschluss bei angelegtem zweiten definierten Potenzial zu messen, um eine zweite Spannungsangabe zu erhalten;

wobei das Steuergerät ausgebildet ist, um einen Korrekturfaktor als Steigung einer von der ersten und der zweiten Spannungsangabe definierten Gerade zu ermitteln, wobei durch den Korrekturfaktor eine gemessene Spannung an dem Motoranschluss beaufschlagbar ist, um die reale Klemmenspannung zu erhalten.

Gemäß einem weiteren Aspekt ist ein Motorsystem mit einer elektrischen Maschine, einem Steuergerät und der obigen Vorrichtung vorgesehen.

Gemäß einem weiteren Aspekt ist ein Computerprogrammprodukt vorgesehen, das ein Computerprogramm enthält, das, wenn es auf einer Datenverarbeitungseinheit ausgeführt wird, das obige Verfahren ausführt.

Kurzbeschreibung der Zeichnungen

Bevorzugte Ausführungsformen werden nachfolgend an Hand der beigefügten Zeichnungen näher erläutert. Es zeigen:

Figur 1 eine schematische Darstellung eines Motorsystems mit einer Vorrichtung zum Messen der Klemmenspannungen; und
Figur 2 ein Flussdiagramm zur Veranschaulichung eines Verfahrens zum Kalibrieren einer Spannungsmessung zur Messung einer Klemmenspannung an einem Motoranschluss eines Elektromotors.

Beschreibung von Ausführungsformen

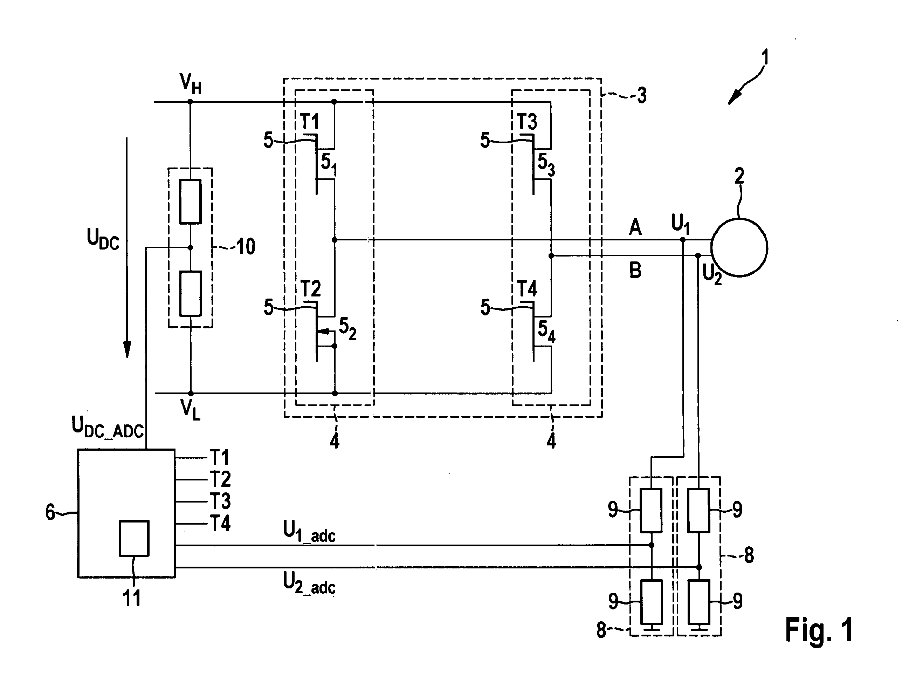

Figur 1 zeigt eine schematische Darstellung eines Motorsystems 1 mit einem Elektromotor 2 als eine elektrische Maschine der über eine Treiberschaltung 3 elektrisch angesteuert wird. Die Treiberschaltung 3 weist im vorliegenden Ausführungsbeispiel zwei Inverterschaltungen 4 in Form von Halbbrückenschaltungen auf, die jeweils eine Reihenschaltung von zwei Leistungshalbleiterschaltern 5 aufweisen. Die Leistungshalbleiterschalter 5 sind beispielsweise - je nach Anwendung und Leistungsbereich - als Leistungs-MOSFET, Thyristoren, IGBT oder dergleichen ausgeführt. Die Inverterschaltungen 4 sind mit einem hohem Versorgungspotenzial $V_H$ und einem niedrigem Versorgungspotenzial $V_L$ verbunden. Eine Versorgungsspannung $U_{DC}$ entspricht der Differenz zwischen dem hohen Versorgungspotenzial $V_H$ und dem niedrigem Versorgungspotenzial $V_L$.

Im in Fig. 1 gezeigten Ausführungsbeispiel mit zwei Inverterschaltungen 4 umfasst die erste Inverterschaltung 4 den ersten und den zweiten Leistungshalbleiterschalter 51, 52 und die zweite Inverterschaltung 4 den dritten und den vierten Leistungshalbleiterschalter $5_3$, $5_4$. Die Leistungshalbleiterschalter 5 werden über entsprechende Ansteuersignale T1 bis T4 von einer Steuereinheit 6 angesteuert, so dass sie entweder geschlossen (leitend geschaltet) oder geöffnet (nicht leitend geschaltet) werden. Die Ansteuerung der Leistungshalbleiterschalter 5 kann in bekannter Weise erfolgen, beispielweise durch eine Pulsweitenmodulation, bei der die Leistungshalbleiterschalter 5 bei einer Inverterschaltung 4 wechselweise geschlossen und geöffnet werden. Die Zeitdauer, während der der erste Leistungshalbleiterschalter $5_1$, der den Elektromotor 2 mit einem hohen Versorgungspotenzial $V_H$ verbindet, im Verhältnis zu der gesamten Zeitdauer eines Ansteuerzyklus das Tastverhältnis angibt, bestimmt die dem Elektromotor 2 bereitgestellte elektrische Leistung.

Zur optimierten Ansteuerung der Inverterschaltungen 4 durch das Steuergerät 6 ist es hilfreich, die Klemmenspannungen U1, U2 an den Motoranschlüssen A, B zu erfassen und dem Steuergerät 6 eine entsprechende Spannungangabe zur Verfügung zu stellen. Die Klemmenspannungen U1, U2 werden abgegriffen und einer jeweiligen Aufbereitungsschaltung 8 (hier beispielhaft als Spannungsteiler ausgeführt) zugeführt. Die Aufbereitungsschaltung 8 liefert ein lineares Abbild der jeweiligen Klemmenspannung, wobei die Klemmenspannung U1, U2 mit einem konstanten Faktor und optional einem Offset beaufschlagt ist. Die jeweiligen Aufbereitungsschaltungen 8 stellen eine aufbereitete Klemmenspannung U1_adc, U2_adc zur Verfügung. Beispielhaft als Spannungsteiler ausgeführt, weisen die jeweiligen Aufbereitungsschaltungen 8 dazu eine Serienschaltung von zwei Widerständen 9 auf, wobei die aufbereiteten Klemmenspannungen U1_adc, U2_adc an einem Zwischenpunkt zwischen den beiden Widerständen 9 abgegriffen werden. Das Teilungsverhältnis ergibt sich in bekannter Weise aus den Widerstandswerten der Widerstände 9 des Spannungsteilers 8. Die aufbereiteten Klemmenspannungen U1_adc, U2_adc werden einem jeweiligen Analog-Digital-Wandler-Eingang des Steuergerätes 6 zur Verfügung gestellt.

Das Steuergerät 6 enthält einen oder mehrere Analog-Digital-Wandler, um die Spannungswerte der aufbereiteten Klemmenspannungen U1_adc, U2_adc zu ermitteln. Beispielhaft als Spannungsteiler ausgeführt, bestimmen die Widerstände 9 der Spannungsteiler 8 den konstanten Korrekturfaktor, um den die jeweilige Klemmenspannung U1, U2 aufbereitet wird. Dieser Korrekturfaktor muss bekannt sein, hängt jedoch stark von den Widerstandswerten der für die Spannungsteiler 8 verwendeten Widerstände 9 ab.

Da eine Realisierung der Spannungsteiler 8 mit Präzisionswiderständen aufwändig und kostenintensiv ist, wird nun vorgeschlagen, dass ein Kalibrierungsverfahren durchgeführt wird, mit dem ein Berechnungsfaktor ermittelt werden kann, mit dem aus der aufbereiteten Klemmenspannung U1_adc, U2_adc die tatsächliche Klemmenspannung U1, U2 ermittelt werden kann. Dazu ist vorgesehen die Versorgungspannung UDC, mittels einer weiteren Aufbereitungsschaltung 10 zu erfassen. Diese kann beispielsweise mit Hilfe eines weiteren Spannungsteilers 10 durchgeführt werden, so dass eine aufbereitete Versorgungsspannung UDC_adc an das Steuergerät 6 angelegt wird, um dort durch einen oder mehrere zugeordnete Analog-Digital-Wandler 11 zum Messen der anliegenden Spannungen erfasst zu werden. Das Steuergerät 6 ermittelt aus dem Teilungsfaktor des weiteren Spannungsteilers 10 und aus der aufbereiteten Versorgungspannung UDC_adc die an der Treiberschaltung 3 anliegende Versorgungsspannung UDC.

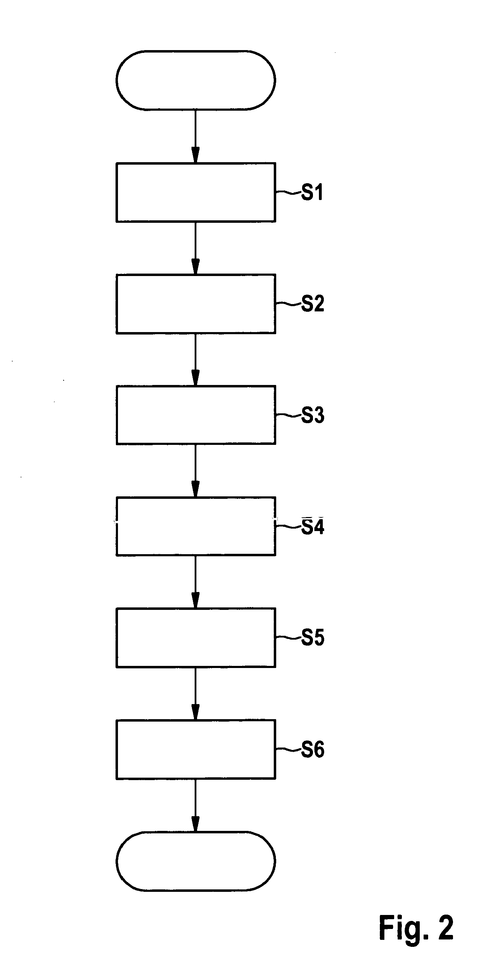

In Figur 2 ist ein Flussdiagramm zur Veranschaulichung des Verfahrens zum Kalibrieren der Spannungsmessung zur Messung einer der Klemmenspannungen U1, U2 an den Motoranschlüssen A, B dargestellt.

Zunächst wird in Schritt S1 eine Spannungsmessung der Versorgungspannung UDC durchgeführt. In dem nächsten Schritt S2 wird der erste Leitungshalbleiterschalter $5_1$ geschlossen (und der zweite Leitungshalbleiterschalter $5_2$ bleibt geöffnet), um an den ersten Motoranschluss A das hohe Versorgungspotenzial $V_H$ anzulegen. In dem Steuergerät 6 wird in Schritt S3 die resultierende aufbereitete Klemmenspannung U1_adc (U1 = UDC) gemessen.

Als nächstes wird in Schritt S4 bei geöffnetem erstem Leistungshalbleiterschalter $5_1$ der zweite Leistungshalbleiterschalter $5_2$ mit Hilfe des zweiten Ansteuersignals T2 geschlossen, um das niedrige Versorgungspotenzial $V_L$ an den ersten Motoranschluss A anzulegen. Es wird anschließend in Schritt S5 die aufbereitete Klemmenspannung U1_adc (U1 = 0) in diesem Fall gemessen. Sobald beide Abgleichpunkte (Anlegen des hohen Versorgungspotenzials $V_H$ und des niedrigen Versorgungspotenzials $V_L$) bekannt sind, können in Schritt S6 die Koeffizienten (Linearfaktor d.h. Steigung der Geraden: LF, Offset: OF) des linearen Zusammenhangs zwischen U1 und U1_adc bestimmt werden. Es gilt:

$$U1 = \frac{U1\_adc - U1\_adc\,(U1 = 0)}{U1\_adc\,(U1 = UDC) - U1\_adc\,(U1 = 0)} \cdot UDC\,(U1 = UDC)$$

Mit dem Linearfaktor LF:

$$LF = \frac{UDC}{U1\_adc\,(U1 = UDC) - U1\_adc\,(U1 = 0)}$$

Und dem Offset OF:

$$OF = \frac{-U1\_adc\,(U1 = 0) \cdot UDC\,(U1 = UDC)}{U1\_adc\,(U1 = UDC) - U1\_adc\,(U1 = 0)}$$

Der Linearfaktor entspricht dabei dem Korrekturfaktor, der eine Steigung einer Übertragungsfunktion zwischen einer gemessenen, aufbereiteten Spannung und der tatsächlichen Klemmspannung angibt. Der Offset entspricht dem konstanten Anteil der Übertragungsfunktion und kann unter Umständen vernachlässigt werden, sollte die Aufbereitungsschaltung 8 keinen Offset aufweisen, wie in der beispielhafte Ausführungsform des Spannungsteilers.

Da bei bestimmten Betriebsbedingungen ein Strom in den Elektromotor 2 fließen könnte, muss bei der Kalibrierung ein solcher Strom berücksichtigt werden. In diesem Fall gilt bei eingeschaltetem ersten Leistungshalbleiterschalter $5_1$ U1 = UDC - $R_{51}$ x I, wobei $R_{51}$ den Durchlasswiderstand des ersten Leistungshalbleiterschalters $5_1$ darstellt. Ist der zweite Leistungshalbleiterschalter $5_2$ geschlossen gilt U1 - $R_{52}$ x I, wobei $R_{52}$ den Durchlasswiderstand des zweiten Leistungshalbleiterschalters $5_2$ darstellt. Im Allgemeinen gilt: $R_{51}$ = $R_{52}$.

Die Messung der zweiten Klemmenspannung U2 wird analog zur Messung der ersten Klemmenspannung U1 in einem entsprechenden Verfahren durchgeführt, wobei nacheinander zunächst der dritte Leistungshalbleiterschalter $5_3$ geschlossen und anschließend der vierte Leistungshalbleiterschalter $5_4$ geschlossen wird.

In dem in Figur 1 gezeigtem Ausführungsbeispiel ist die Messung der Spannung zur Kalibrierung mit Hilfe von Analog-Digital-Wandlern im Steuergerät 6 realisiert. Alternativ kann zur Kalibrierung die Spannungsmessung extern vorgenommen werden, z.B. mit geeigneten Spannungsmessern und daraus ein entsprechender Korrekturfaktor ermittelt werden, der in dem Steuergerät 6 vor der Inbetriebnahme des Motorsystems gespeichert wird. Auf diese Weise lässt sich ohne ein präzises Vermessen der Bauteile der Aufbereitungsschaltung 8 - zum Beispiel die Widerstände 9 - direkt ein Faktor ermitteln, mit dem die jeweils gemessene aufbereitete Spannung beaufschlagt werden muss, um die entsprechenden Klemmenspannungen U1, U2 zu ermitteln.

**Patentansprüche**

**1.** Verfahren zur Kalibrierung einer Messung einer Klemmenspannung einer Treiberschaltung (3) für eine elektrische Maschine (2) mit Hilfe einer Aufbereitungsschaltung (8), mit folgenden Schritten:

- Schalten der Treiberschaltung (3), so dass ein erstes definiertes Potenzial, insbesondere ein erstes Versorgungspotenzial, an einen Klemmenanschluss angelegt wird;
- Messen einer Klemmenspannung (U1, U2) an einem Motoranschluss (A, B) bei angelegtem ersten definierten Potenzial, um eine erste Spannungsangabe zu erhalten, wobei die erste Spannungsangabe bei dem angelegten ersten definierten Potenzial durch Messen einer durch die Aufbereitungsschaltung (8) aufbereiteten Spannung (U1_adc, U2_adc) erhalten wird, die sich durch eine, insbesondere lineare Abbildung der an dem Motoranschluss (A, B) anliegenden Klemmenspannung (U1, U2) ergibt;
- Schalten der Treiberschaltung (3), so dass ein zweites definiertes Potenzial, insbesondere ein zweites Versorgungspotenzial, an den Klemmenanschluss angelegt wird;
- Messen der Klemmenspannung (U1, U2) an dem Motoranschluss (A, B) bei angelegtem zweiten Potenzial, um eine zweite Spannungsangabe zu erhalten, wobei die zweite Spannungsangabe bei dem angelegten zweiten definierten Potenzial durch Messen einer durch die Aufbereitungsschaltung aufbereiteten Spannung (U1_adc, U2_adc) erhalten wird, die sich durch eine insbesondere lineare Abbildung der an dem Motoranschluss (A, B) anliegenden Klemmenspannung (U1, U2) ergibt;
- Ermitteln eines Korrekturfaktors als Steigung einer von der ersten und der zweiten Spannungsangabe definierten Gerade, wobei mit dem Korrekturfaktor ein an dem Motoranschluss (A, B) über die Aufbereitungsschaltung (8) gemessener Spannungswert beaufschlagbar ist, um die reale Klemmenspannung zu erhalten.

2.  Verfahren nach Anspruch 1, wobei das erste definierte Potenzial einem ersten Versorgungspotenzial ($V_H$) und das zweite definierte Potenzial einem zweiten Versorgungspotenzial ($V_L$) entsprechen und wobei die Versorgungsspannung ($U_{DC}$) der Spannungsdifferenz zwischen dem ersten und dem zweiten Versorgungspotenzial ($V_H$, $V_L$) entspricht, wobei zur Ermittlung des Korrekturfaktors die Versorgungsspannung gemessen wird, wobei der Korrekturfaktor als das Verhältnis zwischen der Versorgungsspannung ($U_{DC}$) und der Differenz zwischen dem ersten Versorgungspotenzial ($V_H$) und dem zweiten Versorgungspotenzial ($V_L$) ermittelt wird.

3.  Verfahren nach Anspruch 1 oder 2, wobei weiterhin aus der ersten und der zweiten Spannungsangabe ein Offset ermittelt wird, wobei mit dem Offset eine an dem Motoranschluss gemessene Klemmenspannung beaufschlagbar ist, um die reale Klemmenspannung zu erhalten.

4.  Verfahren zum Bestimmen einer aktuellen Klemmenspannung, mit folgenden Schritten:

- Messen der Klemmenspannung an dem Motoranschluss, um eine Spannungsangabe zu erhalten;
- Ermitteln der aktuellen Klemmenspannung aus der Spannungsangabe und aus dem gemäß dem Verfahren nach einem der Ansprüche 1 bis 3 ermittelten Korrekturfaktor.

5.  Vorrichtung zum Kalibrieren einer Messung einer Klemmenspannung einer Treiberschaltung (3) für eine elektrische Maschine (2), umfassend:

- ein Steuergerät (6), das ausgebildet ist,

- um für eine erste Messung die Treiberschaltung (3) anzusteuern, so dass ein erstes definiertes Potenzial, insbesondere ein ersten Versorgungspotenzial, an einen Klemmenanschluss angelegt wird;
- um für eine zweite Messung die Treiberschaltung (3) anzusteuern, so dass ein zweites definiertes Potenzial, insbesondere ein zweites Versorgungspotenzial, an den Klemmenanschluss angelegt wird;

- eine Aufbereitungsschaltung (8), die ausgebildet ist, um eine durch das Potenzial an dem Klemmenanschluss bestimmte Klemmenspannung (U1, U2) zu modifizieren, so dass eine aufbereitete Klemmenspannung (U1_adc, U2_adc) erhalten wird;
- eine Messeinheit (11), die ausgebildet ist,

- um bei der ersten Messung die aufbereitete Klemmenspannung (U1_adc, U2_adc) an einem Motoranschluss bei angelegtem ersten definierten Potenzial zu messen, um eine erste Spannungsangabe zu erhalten;
- um bei der zweiten Messung die aufbereitete Klemmenspannung (U1_adc, U2_adc) an dem Motoranschluss bei angelegtem zweiten definierten Potenzial zu messen, um eine zweite Spannungsangabe zu erhalten; **dadurch gekennzeichnet, dass**

das Steuergerät (6) ausgebildet ist, um einen Korrekturfaktor als Steigung einer von der ersten und der zweiten Spannungsangabe definierten Gerade zu ermitteln, wobei durch den Korrekturfaktor ein an dem Motoranschluss über die Aufbereitungsschaltung (8) gemessener Spannungswert beaufschlagbar ist, um die reale Klemmenspannung zu erhalten.

6. Motorsystem mit einer elektrischen Maschine (2), einem Steuergerät und einer Vorrichtung nach Anspruch 5.

7. Computerprogrammprodukt, das ein Computerprogramm enthält, das, wenn es auf einer Datenverarbeitungseinheit ausgeführt wird, das Verfahren nach einem der Ansprüche 1 bis 4 ausführt.

**Claims**

1. Method for calibrating a measurement of a terminal voltage of a driver circuit (3) for an electric machine (2) with the aid of a conditioning circuit (8), comprising the following steps:

   - switching the driver circuit (3), such that a first defined potential, in particular a first supply potential, is applied to a terminal connection;
   - measuring a terminal voltage (U1, U2) at a motor connection (A, B) when the first defined potential is applied, in order to obtain a first voltage indication, wherein the first voltage indication, when the first defined potential is applied, is obtained by the measurement of a voltage (U1_adc, U2_adc) which is conditioned by the conditioning circuit (8) and which arises as a result of an, in particular linear, mapping of the terminal voltage (U1, U2) present at the motor connection (A, B);
   - switching the driver circuit (3), such that a second defined potential, in particular a second supply potential, is applied to the terminal connection;
   - measuring the terminal voltage (U1, U2) at the motor connection (A, B) when the second defined potential is applied, in order to obtain a second voltage indication, wherein the second voltage indication, when the second defined potential is applied, is obtained by the measurement of a voltage (U1_adc, U2_adc) which is conditioned by the conditioning circuit and which arises as a result of an, in particular linear, mapping of the terminal voltage (U1, U2) present at the motor connection (A, B);
   - determining a correction factor as a gradient of a straight line defined by the first and second voltage indications, wherein the correction factor can be applied to a voltage value measured at the motor connection (A, B) by means of the conditioning circuit (8), in order to obtain the real terminal voltage.

2. Method according to Claim 1, wherein the first defined potential corresponds to a first supply potential ($V_H$) and the second defined potential corresponds to a second supply potential ($V_L$), and wherein the supply voltage ($U_{DC}$) corresponds to the voltage difference between the first and second supply potentials ($V_H$, $V_L$), wherein the supply voltage is measured for the purpose of determining the correction factor, wherein the correction factor is determined as the ratio between the supply voltage ($U_{DC}$) and the difference between the first supply potential ($V_H$) and the second supply potential ($V_L$).

3. Method according to Claim 1 or 2, wherein an offset is furthermore determined from the first and second voltage indications, wherein the offset can be applied to a terminal voltage measured at the motor connection, in order to obtain the real terminal voltage.

4. Method for determining a present terminal voltage, comprising the following steps:

   - measuring the terminal voltage at the motor connection, in order to obtain a voltage indication;
   - determining the present terminal voltage from the voltage indication and from the correction factor determined according to the method according to any of Claims 1 to 3.

5. Device for calibrating a measurement of a terminal voltage of a driver circuit (3) for an electric machine (2), comprising:

   - a control unit (6) designed

     - to drive the driver circuit (3) for a first measurement, such that a first defined potential, in particular a first supply potential, is applied to a terminal connection;
     - to drive the driver circuit (3) for a second measurement, such that a second defined potential, in particular a second supply potential, is applied to the terminal connection;

- a conditioning circuit (8) designed to modify a terminal voltage (U1, U2) determined by the potential at the terminal connection, such that a conditioned terminal voltage (U1_adc, U2_adc) is obtained;
- a measuring unit (11) designed

- to measure, in the case of the first measurement, the conditioned terminal voltage (U1 adc, U2_adc) at a motor connection when the first defined potential is applied, in order to obtain a first voltage indication;
- to measure, in the case of the second measurement, the conditioned terminal voltage (U1_adc, U2_adc) at the motor connection when the second defined potential is applied, in order to obtain a second voltage indication;

**characterized in that** the control unit (6) is designed to determine a correction factor as a gradient of a straight line defined by the first and second voltage indications, wherein the correction factor can be applied to a voltage value measured at the motor connection by means of the conditioning circuit (8), in order to obtain the real terminal voltage.

6. Motor system comprising an electric machine (2), a control unit and a device according to Claim 5.

7. Computer program product containing a computer program which, when it is executed on a data processing unit, performs the method according to any of Claims 1 to 4.

**Revendications**

1. Procédé de calibrage d'une mesure d'une tension de bornes d'un circuit d'attaque (3) pour une machine électrique (2) à l'aide d'un circuit de conditionnement (8), comprenant les étapes suivantes :

- commutation du circuit d'attaque (3) de sorte qu'un premier potentiel défini, notamment un premier potentiel d'alimentation, soit appliqué à un raccord de borne ;
- mesure d'une tension de borne (U1, U2) à un raccord de moteur (A, B) lorsque le premier potentiel défini est appliqué afin d'obtenir une première indication de tension, la première indication de tension, lorsque le premier potentiel défini est appliqué, étant obtenue en mesurant une tension (U1_adc, U2_adc) conditionnée par le circuit de conditionnement (8), laquelle résulte d'une représentation notamment linéaire de la tension de borne (U1, U2) appliquée à la borne de moteur (A, B) ;
- commutation du circuit d'attaque (3) de sorte qu'un deuxième potentiel défini, notamment un deuxième potentiel d'alimentation, soit appliqué au raccord de borne ;
- mesure de la tension de borne (U1, U2) au raccord de moteur (A, B) lorsque le deuxième potentiel est appliqué afin d'obtenir une deuxième indication de tension, la deuxième indication de tension, lorsque le deuxième potentiel défini est appliqué, étant obtenue en mesurant une tension (U1_adc, U2_adc) conditionnée par le circuit de conditionnement, laquelle résulte d'une représentation notamment linéaire de la tension de borne (U1, U2) appliquée à la borne de moteur (A, B) ;
- détermination d'un facteur de correction en tant que pente d'une droite définie par la première et la deuxième indication de tension, le facteur de correction pouvant être appliqué à une valeur de tension mesurée à la borne de moteur (A, B) par le biais du circuit de conditionnement (8) afin d'obtenir la tension de borne réelle.

2. Procédé selon la revendication 1, selon lequel le premier potentiel défini correspond à un premier potentiel d'alimentation ($V_H$) et le deuxième potentiel défini correspond à un deuxième potentiel d'alimentation ($V_L$) et la tension d'alimentation ($U_{DC}$) correspond à la différence de tension entre le premier et le deuxième potentiel d'alimentation ($V_H$, $V_L$), la tension d'alimentation étant mesurée pour déterminer le facteur de correction, le facteur de correction étant déterminé comme étant le rapport entre la tension d'alimentation ($U_{DC}$) et la différence entre le premier potentiel d'alimentation ($V_H$) et le deuxième potentiel d'alimentation ($V_L$).

3. Procédé selon la revendication 1 ou 2, selon lequel un décalage est en outre déterminé à partir de la première et de la deuxième indication de tension, le décalage pouvant être appliqué à une tension de borne mesurée au raccord de moteur afin d'obtenir la tension de borne réelle.

4. Procédé de détermination d'une tension de borne actuelle, comprenant les étapes suivantes :

- mesure de la tension de borne au raccord de moteur afin d'obtenir une indication de tension ;
- détermination de la tension de borne actuelle à partir de l'indication de tension et à partir du facteur de correction déterminé conformément au procédé selon l'une des revendications 1 à 3.

5. Dispositif de calibrage d'une mesure d'une tension de bornes d'un circuit d'attaque (3) pour une machine électrique (2), comprenant :

- un contrôleur (6) qui est configuré

- pour commander le circuit d'attaque (3) pour une première mesure de sorte qu'un premier potentiel défini, notamment un premier potentiel d'alimentation, soit appliqué à un raccord de borne ;
- pour commander le circuit d'attaque (3) pour une deuxième mesure de sorte qu'un deuxième potentiel défini, notamment un deuxième potentiel d'alimentation, soit appliqué au raccord de borne ;

- un circuit de conditionnement (8) qui est configuré pour modifier une tension de borne (U1, U2) définie par le potentiel au raccord de borne de manière à obtenir une tension de borne conditionnée (U1_adc, U2_adc) ;
- une unité de mesure (11) qui est configurée

- pour, lors de la première mesure, mesurer la tension de borne conditionnée (U1_adc, U2_adc) à une borne de moteur lorsque le premier potentiel défini est appliqué afin d'obtenir une première indication de tension ;
- pour, lors de la deuxième mesure, mesurer la tension de borne conditionnée (U1_adc, U2_adc) à la borne de moteur lorsque le deuxième potentiel défini est appliqué afin d'obtenir une deuxième indication de tension ;

**caractérisé en ce que**
le contrôleur (6) est configuré pour déterminer un facteur de correction en tant que pente d'une droite définie par la première et la deuxième indication de tension, le facteur de correction pouvant être appliqué à une valeur de tension mesurée à la borne de moteur par le biais du circuit de conditionnement (8) afin d'obtenir la tension de borne réelle.

6. Système de moteur comprenant une machine électrique (2), un contrôleur et un dispositif selon la revendication 5.

7. Produit programme informatique qui contient un programme informatique qui, lorsqu'il est exécuté sur une unité de traitement de données, met en oeuvre le procédé selon l'une des revendications 1 à 4.

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10359236 B3
- DE 19947301 C1
- DE 19644765 A1